# EUROPEAN PATENT SPECIFICATION

(11) **EP 4 358 139 B1**
(45) Date of publication and mention of the grant of the patent: **27.05.2026**
(21) Application number: 21953763.6
(22) Date of filing: 19.08.2021
(51) Int. Cl.: H10N 50/85, H10N 50/10, H10N 50/01, H10B 61/00, G11C 11/16

(54) **MAGNETIC DEVICE COMPRISING A MAGNETIC TUNNEL JUNCTION, MANUFACTURING METHOD THEREFOR, AND ELECTRONIC DEVICE WITH A MAGNETIC MEMORY COMPRISING THE MAGNETIC DEVICE**
MAGNETISCHE VORRICHTUNG MIT EINEM MAGNETISCHEN TUNNELÜBERGANG, VERFAHREN ZU IHRER HERSTELLUNG UND ELEKTRONISCHE VORRICHTUNG MIT EINEM MAGNETISCHEN SPEICHER, DER DIE MAGNETISCHE VORRICHTUNG ENTHÄLT
DISPOSITIF MAGNÉTIQUE COMPRENANT UNE JONCTION À EFFET TUNNEL MAGNÉTIQUE, SON PROCÉDÉ DE FABRICATION, ET DISPOSITIF ÉLECTRONIQUE AVEC MÉMOIRE MAGNÉTIQUE COMPRENANT LE DISPOSITIF MAGNÉTIQUE

(43) Date of publication of application: 24.04.2024
(73) Proprietor: Huawei Technologies Co., Ltd., Shenzhen, Guangdong 518129 (CN)
(72) Inventor: XU, Zhongqi, Shenzhen, Guangdong 518129 (CN); QIN, Qing, Shenzhen, Guangdong 518129 (CN); ZHOU, Xue, Shenzhen, Guangdong 518129 (CN); JIAO, Huifang, Shenzhen, Guangdong 518129 (CN); QIU, Xuepeng, Shanghai 200092 (CN); ZHU, Wei, Shanghai 200092 (CN); YANG, Huanglin, Shanghai 200092 (CN)
(74) Representative: Gill Jennings & Every LLP
(86) International application number: PCT/CN2021/113579
(87) International publication number: WO 2023/019519

(56) References cited:
- WO-A1-2022/205235
- CN-A- 102 024 903
- CN-A- 108 665 921
- CN-A- 110 412 081
- US-A1- 2007 074 317
- US-A1- 2007 228 501
- US-A1- 2011 062 537
- US-A1- 2011 063 899
- US-A1- 2013 221 460
- US-A1- 2015 303 373
- US-A1- 2018 277 517

## Description

### TECHNICAL FIELD

The present invention relates to the field of magnetic tunnel junction technologies, and in particular, to a magnetic device comprising a magnetic tunnel junction (MTJ), its manufacturing method, and an electronic device with a magnetic memory comprising the magnetic device.

### BACKGROUND

A ferrimagnetic material is a material different from a ferromagnetic material and an antiferromagnetic material, but has characteristics of the ferromagnetic material and the antiferromagnetic material. As an important material in ferrimagnetic materials, a transition metal rare earth ferrimagnetic alloy (TM-RE) material has been widely studied and applied owing to properties such as an amorphous state, an adjustable macroscopic net magnetic moment that can be achieved by adjusting alloy elements and a component ratio, and bulk perpendicular magnetic anisotropy (b-PMA).

The TM-RE material has a broad application prospect in an MTJ. However, the TM-RE material has poor annealing tolerance of perpendicular magnetic anisotropy, and in a process of preparing a magnetic device including an MTJ, a temperature during a back-end annealing process usually exceeds 400°C and remains for more than half an hour. Consequently, the TM-RE material cannot be directly applied to the MTJ. US 2011/0062537 A1 discloses a magnetic element using ferrimagnetic materials for spin-transfer switching, particularly a memory device including an MTJ wherein the free layer or the reference layer is strongly exchange-coupled to a PMA layer via a non-magnetic layer. The non-magnetic layer may have a metal oxide/metal/metal oxide layered structure and the PMA layer may include an amorphous TM-RE alloy. US 2018/0277517 A1 discloses MTJs comprising a suboxide layer/free layer/tunnel barrier/pinned layer stack wherein, in case of PMA configuration, the free layer and/or the pinned layer may be of amorphous TM-RE alloy. US 2015/0303373 A1 teaches PMA-MTJs with composite free layer and/or pinned layer comprising a CoFeB layer and a TM-RE layer. US 2007/0074317 A1 discloses a spin-transfer memory MTJ with a ferrimagnetic free layer, particularly comprising a stack of TM-RE layer/insertion layer/spin current enhancement layer, and a capping layer of refractory metal or alloy on the TM-RE layer.

### SUMMARY

The present invention is embodied by a magnetic device comprising a magnetic tunnel junction according to independent claim 1, its manufacturing method according to independent claim 9, and an electronic device with a magnetic memory comprising the magnetic device according to claim 12, to resolve a problem that a TM-RE alloy material cannot be applied to an MTJ due to poor annealing tolerance of perpendicular magnetic anisotropy of the TM-RE alloy material.

This application provides a magnetic device (which may also be referred to as an MTJ device). The magnetic device includes a magnetic tunnel junction (MTJ). The magnetic tunnel junction includes a pinned layer, a reference layer, a tunneling barrier layer, and a free layer that are sequentially stacked. At least one of the pinned layer or the free layer includes a transition metal rare earth ferrimagnetic alloy thin film (TM-RE thin film) and an oxide layer located on a surface of the TM-RE thin film, that is, the oxide layer is located on a surface of the TM-RE thin film close to or away from the tunneling barrier layer. That is, the free layer of the MTJ may include the TM-RE thin film and the oxide layer, or the pinned layer of the MTJ may include the TM-RE thin film and the oxide layer, or the TM-RE thin film and the oxide layer are disposed in both the free layer and the pinned layer of the MTJ.

In the magnetic device, TM-RE thin films are used in some film layers of the MTJ, and the oxide layer is disposed on at least one surface of the TM-RE thin film. In this way, in a back-end annealing process of the magnetic device, oxygen atoms in the oxide layer diffuse into a TM-RE material, and a 2p orbital of the oxygen atom and a 3d orbital of a transition metal element in the TM-RE material include z-component (that is, a component perpendicular to a TM-RE direction) orbit hybridization, so that an electron spin arrangement orientation of the TM-RE material is tended to be perpendicular to a thin film direction, that is, an additional perpendicular magnetic anisotropy source is provided for the TM-RE thin film by using the oxide layer, to improve annealing tolerance of the perpendicular magnetic anisotropy of the TM-RE thin film, and further enable the TM-RE material to be applied to the MTJ.

In addition, because the TM-RE material has a characteristic of an amorphous state, for a thin film grown adjacent to the TM-RE material, interlayer stress due to lattice mismatch and roughness accumulation caused by growth of a plurality of layers of structures can be avoided. In this way, another film layer that has a high requirement for interface flatness can be directly formed on the surface of the TM-RE thin film, and interface flatness is ensured without a need of manufacturing an additional intermediate film layer, to improve overall flatness of each film layer of the magnetic device and overall performance of the magnetic device.

In some possible implementations, the TM-RE thin film includes a TM-RE material. A transition metal element in the TM-RE material includes at least one of Co, Fe, or Ni. A rare earth element in the TM-RE material includes at least one of Tb, Gd, Dy, or Eu.

In some possible implementations, the TM-RE material further includes at least one doping element of Ta, W, Si, B, or C.

In some possible implementations, the TM-RE thin film includes at least one of CoTb, FeTb, CoGd, CoTbB, FeTbB, or CoGdB.

In some possible implementations, an oxide in the oxide layer includes at least one of a magnesium-containing oxide, a copper-containing oxide, an aluminum-containing oxide, a zinc-containing oxide, a nickel-containing oxide, a chromium-containing oxide, a titanium-containing oxide, a silicon-containing oxide, or a selenium-containing oxide.

In some possible implementations, the oxide layer includes at least one of MgO, SiO₂, or MgAlO₃.

The free layer of the MTJ uses a hybrid free layer, and the hybrid free layer includes a ferromagnetic layer, an interlayer spacer, the TM-RE thin film, and the oxide layer that are sequentially stacked. The ferromagnetic layer is in contact with the tunneling barrier layer. That is, the TM-RE thin film and the oxide layer may be applied to the free layer of the MTJ. In this case, the TM-RE thin film and the oxide layer are applied to the hybrid free layer of the MTJ. An additional perpendicular magnetic anisotropy source is provided for the TM-RE thin film by using the oxide layer, to improve the annealing tolerance of the perpendicular magnetic anisotropy of the TM-RE thin film. In addition, the hybrid free layer can provide bulk perpendicular magnetic anisotropy (b-PMA) based on the TM-RE thin film.

Alternatively, the pinned layer of the MTJ includes one or more TM-RE thin films. The oxide layer is disposed on a surface of at least one TM-RE thin film close to and/or away from the tunneling barrier layer. That is, in the pinned layer, the oxide layer may be disposed on an upper surface of the at least one TM-RE thin film, or the oxide layer may be disposed on a lower surface of the at least one TM-RE thin film, or the oxide layer may be disposed on both the upper surface and the lower surface of the at least one TM-RE thin film. In this case, the TM-RE thin film and the oxide layer are applied to the pinned layer of the MTJ. An additional perpendicular magnetic anisotropy source is provided for the TM-RE thin film by using the oxide layer, to improve the annealing tolerance of the perpendicular magnetic anisotropy of the TM-RE thin film. In addition, the TM-RE material, as a ferrimagnetic ferrum material, has a small magnetic moment. This can reduce a leakage magnetic field of the pinned layer, to reduce an offset to the free layer.

The pinned layer is in direct contact with the reference layer by using the TM-RE thin film. In this case, the reference layer may be directly manufactured on a surface of the TM-RE thin film located in the pinned layer. Because the TM-RE thin film formed by using the TM-RE material of the amorphous state can improve flatness of a subsequently grown thin film, there is no need to consider stress generated due to lattice mismatch and roughness accumulation. This can meet a requirement of the reference layer on interface flatness without a need of additionally separately manufacturing a structure conversion layer and simplify a manufacturing process.

In some possible implementations, the pinned layer includes one TM-RE thin film and one oxide layer. The oxide layer is disposed on a surface of the TM-RE thin film away from the tunneling barrier layer.

In some possible implementations, the pinned layer includes two TM-RE thin films and one oxide layer. The oxide layer is located between the two TM-RE thin films.

In some possible implementations, the pinned layer includes two oxide layers and one TM-RE thin film. The TM-RE thin film is located between the two oxide layers.

An embodiment of this application further provides a magnetic device manufacturing method. The manufacturing method may include: manufacturing a magnetic tunnel junction, where the magnetic tunnel junction includes a pinned layer, a reference layer, a tunneling barrier layer, and a free layer that are sequentially stacked, and at least one of the pinned layer or the free layer includes a transition metal rare earth ferrimagnetic alloy thin film and an oxide layer located on a surface of the transition metal rare earth ferrimagnetic alloy thin film; and performing annealing processing on the manufactured magnetic tunnel junction.

According to the magnetic device manufacturing method in this application, the TM-RE thin film and the oxide layer that is in contact with the TM-RE thin film are manufactured in a process in which the pinned layer and/or the free layer are/is formed, so that when the annealing processing is subsequently performed on the formed magnetic tunnel junction, an additional perpendicular magnetic anisotropy source is provided for the TM-RE thin film by using the oxide layer, to improve annealing tolerance of perpendicular magnetic anisotropy of the TM-RE thin film, and further resolve a problem in a conventional technology that a TM-RE alloy material cannot be applied to the MTJ due to poor annealing tolerance of the perpendicular magnetic anisotropy.

In some possible implementations, the manufacturing a magnetic tunnel junction may include: sequentially manufacturing the reference layer, the tunneling barrier layer, a ferromagnetic layer, an interlayer spacer, the transition metal rare earth ferrimagnetic alloy thin film, and the oxide layer, to form the magnetic tunnel junction, where the ferromagnetic layer, the interlayer spacer, the transition metal rare earth ferrimagnetic alloy thin film, and the oxide layer that are sequentially manufactured form the free layer.

In some possible implementations, the manufacturing a magnetic tunnel junction may include: sequentially manufacturing the oxide layer, the transition metal rare earth ferrimagnetic alloy thin film, an interlayer spacer, a ferromagnetic layer, the tunneling barrier layer, and the reference layer, to form the magnetic tunnel junction, where the oxide layer, the transition metal rare earth ferrimagnetic alloy thin film, the interlayer spacer, and the ferromagnetic layer that are sequentially manufactured form the free layer.

For the foregoing two manufacturing manners in which the free layer (a hybrid free layer) of the magnetic tunnel junction is manufactured by using the transition metal rare earth ferrimagnetic alloy thin film and the oxide layer, when the annealing processing is subsequently performed on the formed magnetic tunnel junction, an additional perpendicular magnetic anisotropy source is provided for the TM-RE thin film by using the oxide layer, to improve annealing tolerance of the perpendicular magnetic anisotropy of the TM-RE thin film. In addition, the formed hybrid free layer can provide bulk perpendicular magnetic anisotropy based on the TM-RE thin film.

**In** some possible implementations, the manufacturing a magnetic tunnel junction may include: sequentially manufacturing the oxide layer, the transition metal rare earth ferrimagnetic alloy thin film, the reference layer, the tunneling barrier layer, and the free layer, to form the magnetic tunnel junction, where the oxide layer and the transition metal rare earth ferrimagnetic alloy thin film that are sequentially manufactured form the pinned layer.

**In** some possible implementations, the manufacturing a magnetic tunnel junction may include: sequentially manufacturing the free layer, the tunneling barrier layer, the reference layer, the transition metal rare earth ferrimagnetic alloy thin film, and the oxide layer, to form the magnetic tunnel junction, where the transition metal rare earth ferrimagnetic alloy thin film and the oxide layer that are sequentially manufactured form the pinned layer.

For the foregoing two manufacturing manners in which the pinned layer is manufactured by using the transition metal rare earth ferrimagnetic alloy thin film and the oxide layer, when the annealing processing is subsequently performed on the formed magnetic tunnel junction, an additional perpendicular magnetic anisotropy source is provided for the TM-RE thin film by using the oxide layer, to improve annealing tolerance of the perpendicular magnetic anisotropy of the TM-RE thin film. In addition, a TM-RE material used by the formed TM-RE thin film, as a ferrimagnetic ferrum material, has a small magnetic moment. This can reduce a leakage magnetic field of the pinned layer, to reduce an offset to the free layer.

Further, because the TM-RE thin film formed by using the TM-RE material of an amorphous state can improve flatness of a subsequently grown thin film, there is no need to consider stress generated due to lattice mismatch and roughness accumulation. Therefore, the TM-RE thin film may be in direct contact with the reference layer when the TM-RE thin film is used to manufacture the pining layer. This can meet a requirement of the reference layer on interface flatness without a need of additionally separately manufacturing a structure conversion layer and simplify a manufacturing process.

An embodiment of this application further provides a magnetic memory. The magnetic memory includes a controller and the magnetic device provided in any one of the foregoing possible implementations. The magnetic device is connected to the controller.

An embodiment of this application further provides an electronic device. The electronic device includes a printed circuit board and the magnetic memory provided in any one of the foregoing possible implementations. The magnetic memory is connected to the printed circuit board.

### BRIEF DESCRIPTION OF DRAWINGS

FIGs. 1-4 are schematic diagrams of MTJ device structures known in the art;
FIG. 5 is a schematic diagram of a structure of an MTJ device according to a first embodiment of the present invention;
FIG. 6 is a schematic diagram of an MTJ device manufacturing procedure according to the first embodiment;
FIG. 7 is a diagram of three hysteresis loops of a TM-RE thin film according to the first embodiment;
FIG. 8 is a schematic diagram of a structure of an MTJ device according to a second embodiment of the present invention;
FIG. 9 is a schematic diagram of a structure of an MTJ device according to a variant of the second embodiment;
FIG. 10 is a schematic diagram of an MTJ device manufacturing procedure according to the second embodiment;
FIG. 11 is a schematic diagram of an architecture of an electronic device, possibly according to embodiments of the present invention; and
FIG. 12 is a schematic diagram of a structure of a storage unit in a magnetic memory.

### DESCRIPTION OF EMBODIMENTS

To make the objectives, technical solutions, and advantages of this application clearer, the following clearly describes the technical solutions in this application with reference to the accompanying drawings in this application. It is clear that the described embodiments are merely a part rather than all of embodiments of this application. All other embodiments obtained by a person of ordinary skill in the art based on embodiments of this application without creative efforts shall fall within the protection scope of this application.

In embodiments of the specification, claims, and accompanying drawings of this application, the terms "first", "second", and the like are merely intended for distinguishing and description, and shall not be understood as an indication or implication of relative importance or an indication or implication of an order. Terms such as "connection", and the like are used for indicating interworking or interaction between different components, and may include a direct connection or an indirect connection via another component. In addition, the terms "include", "have", and any variant thereof are intended to cover non-exclusive inclusion, for example, include a series of steps or units. Methods, systems, products, or devices are not necessarily limited to those steps or units that are literally listed, but may include other steps or units that are not literally listed or that are inherent to such processes, methods, products, or devices. "On", "below", "left", "right", and the like are used only relative to the orientation of the components in the accompanying drawings. These directional terms are relative concepts, are used for relative descriptions and clarifications, and may change accordingly as positions at which the components in the accompanying drawings are placed change.

It should be understood that, in this application, "at least one (item)" means one or more, and "a plurality of" means two or more. The term "and/or" is used for describing an association relationship between associated objects, and represents that three relationships may exist. For example, "A and/or B" may represent the following three cases: Only A exists, only B exists, and both A and B exist, where A and B may be singular or plural. The character "/" generally indicates an "or" relationship between the associated objects. "At least one of the following items (pieces)" or a similar expression thereof indicates any combination of these items, including a single item (piece) or any combination of a plurality of items (pieces). For example, at least one item (piece) in a, b, or c may indicate a, b, c, a and b, a and c, b and c, or a, b, and c, where a, b, and c may be singular or plural.

Embodiments of this application provide an electronic device. The electronic device includes a printed circuit board (PCB) and a magnetic device connected to the printed circuit board. A magnetic tunnel junction (MTJ) is disposed in the magnetic device, and the magnetic device may also be referred to as an MTJ device or an MTJ element.

A form of the electronic device is not limited in this application. For example, the electronic device may be an electronic product such as a mobile phone, a tablet computer, a notebook computer, an in-vehicle computer, a smart watch, or a smart band.

An application field of the MTJ device is not limited in this application. For example, the MTJ device may be applied to fields such as a magnetic random access memory (MRAM) and a magnetic sensor.

In the MTJ device provided in embodiments of this application, some film layers of the MTJ may include a transition metal rare earth ferrimagnetic alloy (TM-RE) material, that is, some film layers of the MTJ may include a TM-RE thin film. In addition, an oxide layer that is in direct contact with the TM-RE thin film is disposed on at least one surface (that is, at least one of an upper surface and a lower surface) of the TM-RE thin film, and an additional perpendicular magnetic anisotropy (PMA) source is provided for the TM-RE thin film by using the oxide layer, to improve annealing tolerance of perpendicular magnetic anisotropy of the TM-RE thin film, and further resolve a problem in a conventional technology that a TM-RE alloy material cannot be applied to the MTJ due to poor annealing tolerance of the perpendicular magnetic anisotropy.

How the TM-RE thin film and the oxide layer are disposed is described below with reference to the MTJ.

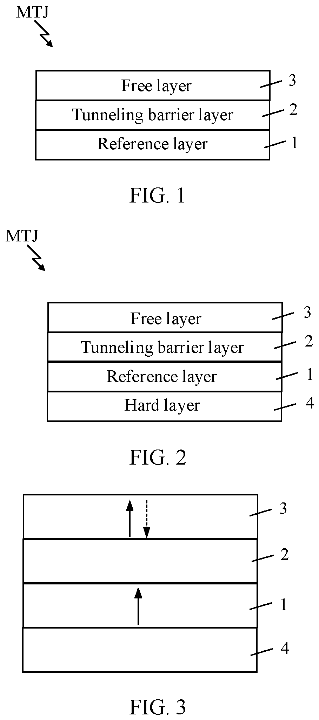

The MTJ is a device that can change a resistance status of the MTJ based on a status of a magnetic material inside the device. As shown in FIG. 1, the MTJ includes a reference layer, a tunneling barrier layer (tunneling barrier layer, which may also be referred to as a tunnel layer) 2, and a free layer 3 that are sequentially stacked. Certainly, in some possible implementations, as shown in FIG. 2, in the MTJ, a pinned layer 4 may be further disposed on a side of the reference layer 1 away from the tunneling barrier layer 2, to fasten a magnetic moment of the reference layer 1 by using the pinned layer 4. The pinned layer 4 may be in direct contact with the reference layer 1, or another film layer (for example, a structure conversion layer) may be disposed between the pinned layer 4 and the reference layer 1. In practice, selection and disposing may be performed based on a requirement. The following embodiments are all described by using an example in which the pinned layer 4 is disposed in the MTJ.

Refer to FIG. 3. In the MTJ, a magnetization direction of the reference layer 1 remains unchanged (that is, magnetism remains unchanged), and magnetism of the free layer 3 changes with a control current or another magnetic reversal mechanism, so that a magnetization direction of the free layer 3 is parallel to or anti-parallel to the magnetization direction of the reference layer 1. When the magnetization direction of the free layer 3 is parallel to the magnetization direction of the reference layer 1, resistance of a current passing along a layer stacking direction (that is, a direction perpendicular to the thin film) of the MTJ is small, and in this case, the MTJ presents low resistance (that is, a low resistance state). When the magnetization direction of the free layer 3 is anti-parallel to the magnetization direction of the reference layer 1, resistance of the current passing along the layer stacking direction of the MTJ is large, and in this case, the MTJ presents high resistance (that is, a high resistance state). In other words, the MTJ can switch between two resistance states (that is, the high resistance state and the low resistance state), and this performance is referred to as tunnel magnetoresistance (TMR) effect.

For the MRAM, the MTJ device and a controller connected to the MTJ device are disposed inside the MRAM. The MRAM can determine a "0" state or a "1" state of stored data by using the tunnel magnetoresistance effect of the MTJ, by using the controller, based on the high resistance and the low resistance of the MTJ, and respectively in correspondence to "0" and "1" of one-byte binary information in information storage, to implement information storage.

For the magnetic sensor, the MTJ device and an induced circuit connected to the MTJ device are disposed inside the magnetic sensor. The magnetic sensor can change the magnetization direction of the free layer by using the tunnel magnetoresistance effect of the MTJ and by using an external magnetic field change, and may deduce the magnetization state of the free layer by reading resistance of the MTJ through the induced circuit, to determine a direction or magnitude of an external magnetic field.

It should be noted herein that, in FIG. 1 and FIG. 2, an example in which the reference layer 1, the tunneling barrier layer 2, and the free layer 3 are sequentially stacked from bottom to top is used for description. In some other embodiments, the reference layer 1, the tunneling barrier layer 2, and the free layer 3 may be sequentially stacked from top to bottom. In this case, the pinned layer 4 is disposed above the reference layer 1. It should be further noted that FIG. 3 is merely an example in which the magnetization direction of the reference layer 1 is upward. In some other embodiments, the magnetization direction of the reference layer 1 may alternatively be downward.

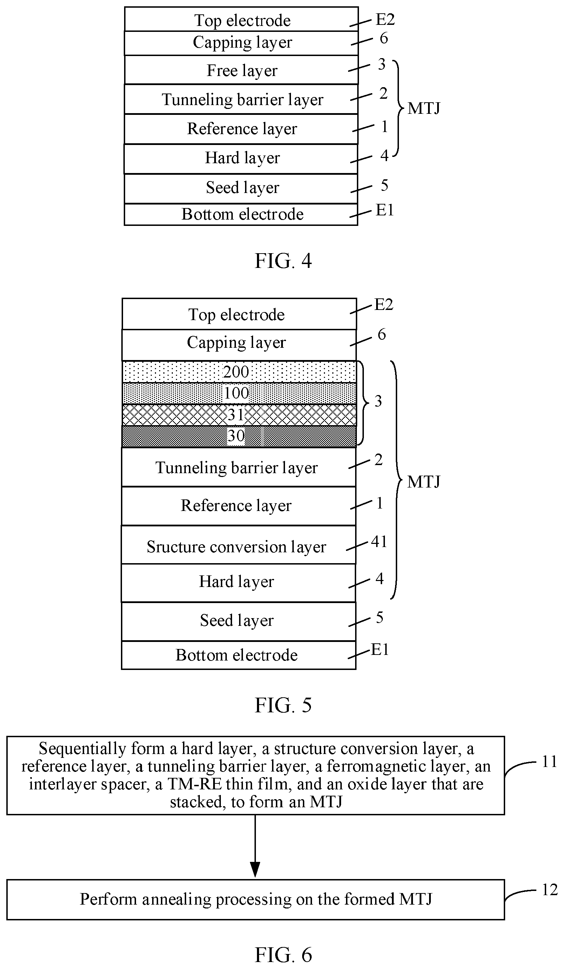

In addition, a person skilled in the art may understand that, based on manufacturing and control of the MTJ device, another film layer structure usually needs to be disposed on two sides of the MTJ, for example, a bottom electrode E1, a top electrode E2, a seed layer 5, a capping layer6, and the like shown in FIG. 4.

For example, a laminated structure of the MTJ may be disposed between the bottom electrode E1 and the top electrode E2, and a control electrical signal can be applied to the MTJ by using the bottom electrode E1 and the top electrode E2. For example, the seed layer 5 may be first formed on a surface of the bottom electrode E1, and then the MTJ is manufactured on the seed layer 5, to provide a good growth plane for manufacturing the MTJ. For example, the capping layer 6 may be disposed on a surface of the free layer 3. The capping layer 6 may be made of metal (such as Pt or Ta), or may be made of non-metal oxide (such as SiO₂). A thickness of the capping layer 6 may be generally 2 nm to 3 nm, but this is not limited thereto.

In the MTJ device provided in embodiments of the present invention, at least one of the free layer 3 and the pinned layer 4 of the MTJ includes the TM-RE thin film, and the oxide layer including the oxide material is disposed on at least one surface (that is, at least one of an upper surface and a lower surface) of the TM-RE thin film. For example, the free layer 3 of the MTJ may include the TM-RE thin film and the oxide layer (for details, refer to the following Embodiment 1). For another example, the pinned layer 4 of the MTJ may include the TM-RE thin film and the oxide layer (for details, refer to the following Embodiment 2). For another example, the TM-RE thin film and the oxide layer are disposed in both the free layer 3 and the pinned layer 4 of the MTJ.

In this case, in a back-end annealing process of the MTJ device, oxygen atoms in the oxide layer diffuse into a TM-RE material, and a 2p orbital of the oxygen atom and a 3d orbital of a transition metal element in the TM-RE material include z-component (that is, a component perpendicular to a TM-RE direction) orbit hybridization, so that an electron spin arrangement orientation of the TM-RE material is tended to be perpendicular to a thin film direction, that is, an additional perpendicular magnetic anisotropy (PMA) source is provided for the TM-RE thin film by using the oxide layer, to improve annealing tolerance of the perpendicular magnetic anisotropy of the TM-RE thin film, and further enable the TM-RE material to be applied to the MTJ.

In addition, because the TM-RE material has a characteristic of an amorphous state, for a thin film grown adjacent to the TM-RE material, interlayer stress due to lattice mismatch and roughness accumulation caused by growth of a plurality of layers of structures can be avoided. In this way, another film layer that has a high requirement for interface flatness can be directly formed on a surface of the TM-RE thin film, and interface flatness is ensured without a need of manufacturing an additional intermediate film layer (for details, refer to disposing in the following Embodiment 2), to improve overall flatness of each film layer of the MTJ device and overall performance of the MTJ device.

For the foregoing perpendicular magnetic anisotropy (PMA), it may be understood that the perpendicular magnetic anisotropy in this application means that spin of an electron of an outer layer of a ferrimagnetic layer is selected to be tended to be perpendicular to a direction of an interface of the ferromagnetic layer in a spatial degree of freedom. An interface of the ferrimagnetic layer may be an interface on which the ferrimagnetic layer is in contact with another layer, for example, an interface on which the TM-RE thin film is in contact with the oxide layer in this application.

For the foregoing annealing tolerance, it may be understood that, when a back-end annealing process or another type of annealing process is performed on the MTJ, the perpendicular magnetic anisotropy of the TM-RE material does not change greatly. Such a capability of maintaining magnetic anisotropy to a specific extent after annealing is called annealing tolerance. The annealing tolerance is related to factors such as element selection, a component ratio, and a doping type of the TM-RE material.

The following schematically describes the material components forming the TM-RE thin film and the oxide layer in embodiments of this application.

For the TM-RE material used in the TM-RE thin film, the transition metal element in the TM-RE material may include at least one of cobalt (Co), ferrum (Fe), or nickel (Ni). However, this application is not limited thereto. A rare earth element in the TM-RE material may include at least one of terbium (Tb), gadolinium (Gd), dysprosium (Dy), or europium (Eu). However, this application is not limited thereto.

**In** some possible implementations, the TM-RE material may further include a doping element. For example, the doping element may be at least one of tantalum (Ta), tungsten (W), silicon (Si), boron (B), or carbon (C). However, this application is not limited thereto.

For example, in some embodiments, the TM-RE material used in the TM-RE thin film may include at least one of cobalt terbium (CoTb), ferrum terbium (FeTb), cobalt gadolinium (CoGd), cobalt terbium boron (CoTbB), ferrum terbium boron (FeTbB), or cobalt gadolinium boron (CoGdB). However, this application is not limited thereto.

It should be noted that, a component ratio occupied by each element (the transition metal element, the rare earth element, and the doping element) of the TM-RE material in the TM-RE thin film is not limited to a specific component ratio, and may be set based on a requirement in practice.

In addition, for the oxide layer, an oxide material forming the oxide layer may include at least one of a magnesium-containing oxide (for example, MgO), a copper-containing oxide (for example, CuO), an aluminum-containing oxide (for example, Al₂O₃), a zinc-containing oxide (for example, ZnO), a nickel-containing oxide (for example, NiO), a chromium-containing oxide (for example, Cr₂O₃ and CrO₂), a titanium-containing oxide (for example, TiO₂), a silicon-containing oxide (for example, SiO₂), or a selenium-containing oxide (for example, SeO₂). However, this application is not limited thereto.

For example, in some embodiments, the oxide used in the oxide layer may include at least one of MgO, SiO₂, or MgAlO₃, but this is not limited thereto.

**In** addition, thicknesses of the oxide layer and the TM-RE thin film in the MTJ device are not specifically limited in this application. In practice, the thicknesses of the oxide layer and the TM-RE thin film are determined based on a specific material and a technological process that are used.

The following schematically describes, by using specific embodiments, how the TM-RE thin film and the oxide layer are disposed in the MTJ device.

### Embodiment 1

In an MTJ device provided in this embodiment, a TM-RE thin film and an oxide layer are used in a free layer 3 of the MTJ. In this case, the free layer 3 of the MTJ may use a hybrid free layer (HFL), and may be specifically disposed as follows.

As shown in FIG. 5, the free layer 3 includes a ferromagnetic layer 30, an interlayer spacer (interlayer spacer or coupling spacer) 31, a TM-RE thin film 100, and an oxide layer 200 that are sequentially stacked from bottom to top. The ferromagnetic layer 30 is in contact with a tunneling barrier layer 2. The oxide layer 200 is disposed on an upper surface (that is, a surface away from the tunneling barrier layer 2) of the TM-RE thin film 100.

Certainly, in some other possible implementations, when the used oxide layer 200 is thin, for example, a thickness of the oxide layer 200 is less than 0.5 nm, the oxide layer 200 may alternatively be disposed on a lower surface (that is, a surface close to the tunneling barrier layer 2) of the TM-RE thin film 100. The following embodiments are all described by using an example in which the oxide layer 200 is disposed on the surface of the TM-RE thin film 100 away from the tunneling barrier layer 2.

In addition, refer to FIG. 5. Other film layers in the MTJ device, for example, a bottom electrode E1, a seed layer 5, a pinned layer 4, a structure conversion layer 41, a reference layer 1, and a tunneling barrier layer 2 that are sequentially provided from bottom to top and that are located below the free layer 3, a capping layer 6 and a top electrode E2 that are located above the free layer 3, and the like may be set with reference to the foregoing content and a conventional technology according to an actual requirement. Details are not described herein again.

It should be noted that, as shown in FIG. 5, in some embodiments, the structure conversion layer 41 is disposed between the pinned layer 4 and the reference layer 1, and a good growth plane can be provided for the reference layer 1 by manufacturing the structure conversion layer 41. Certainly, in some possible implementations, by selecting an appropriate pinned layer 4, the structure conversion layer 41 may not be set.

In addition, as shown in FIG. 6, Embodiment 1 further provides an MTJ device manufacturing method. The manufacturing method includes the following steps.

Step 11: Sequentially manufacture a pinned layer 4, a structure conversion layer 41, a reference layer 1, a tunneling barrier layer 2, a ferromagnetic layer 30, an interlayer spacer 31, a TM-RE thin film 100, and an oxide layer 200, to form an MTJ, as shown in FIG. 5.

The ferromagnetic layer 30, the interlayer spacer 31, the TM-RE thin film 100, and the oxide layer 200 as an entire are used as a free layer 3 (that is, a hybrid free layer) in the MTJ.

For example, the pinned layer 4 may use a Co/Pt (cobalt/platinum) multilayer film, a Co/Pd (cobalt/palladium) multilayer film, a Co/Ir (cobalt/iridium) multilayer film, or the like, but this is not limited thereto.

For example, the structure conversion layer 41 may be made of one or more of materials such as tantalum (Ta), titanium (Ti), titanium nitride (TiN), aluminum (Al), magnesium (Mg), titanium magnesium (TiMg), tungsten (W), or molybdenum (Mo), but this is not limited thereto.

For example, the reference layer 1 may be made of one or more of materials such as CoFeB (cobalt ferrum boron), FeB (ferrum boron), CoFe (cobalt ferrum), or CoB (cobalt boron), but this is not limited thereto.

For example, the tunneling barrier layer 2 may be made of one or more of materials such as MgO, MgAlO₃, AlOₓ (aluminum oxide), MgGdO, TiOₓ (titanium oxide), TaOₓ (tantalum oxide), or MgTiOₓ (magnesium titanium oxide), but this is not limited thereto.

For example, the ferromagnetic layer 30 may be made of one or more of materials such as CoFeB, FeB, CoFe, or CoB, but this is not limited thereto.

For example, the interlayer spacer 31 may be made of one or more of materials such as Ta (tantalum) or Ru (ruthenium), but this is not limited thereto.

For example, the TM-RE thin film 100 may be made of one or more of materials such as CoTb, FeTb, CoGd, CoTbB, FeTbB, or CoGdB, but this is not limited thereto.

For example, the oxide layer 200 may be made of one or more of materials such as MgO, SiO₂, or MgAlO₃, but this is not limited thereto.

Certainly, refer to FIG. 5. It should be understood that, for manufacturing of the entire MTJ device, before step 11 is performed, a bottom electrode E1 and a seed layer 5 that are stacked may be first sequentially formed on a substrate; and then manufacturing of the pinned layer 4, the structure conversion layer 41, the reference layer 1, the tunneling barrier layer 2, and the free layer 3 in step 11 is performed on a surface of the seed layer 5. After step 11, manufacturing of another film layer, for example, manufacturing of a capping layer 6 and a top electrode E2, may continue to be performed on a surface of the free layer 3.

The following schematically describes manufacturing of the TM-RE thin film 100 and the oxide layer 200 in the free layer 3 in step 11.

For example, the manufacturing of the TM-RE thin film 100 and the oxide layer 200 in step 11 may include the following.

For example, in some possible implementations, the TM-RE thin film 100 may be formed by sputtering and growing a TM-RE target material on a surface of the interlayer spacer 31, and then the oxide layer 200 (for example, the MgO layer) is grown on the surface of the TM-RE thin film 100 in a sputtering manner. Certainly, in another possible implementation, the TM-RE thin film 100 may be formed by sputtering and growing a TM target material and an RE target material on the surface of the interlayer spacer 31 in a co-sputtering manner.

For example, the TM-RE thin film 100 may be grown at normal temperature, and a bottom structure before growing is transferred to a vacuum sputtering cavity at indoor normal temperature, where a vacuum degree is higher than 10⁻⁸ Torr.

It may be understood that, before the TM-RE thin film 100 is grown, it needs to be ensured that the bottom structure before growing is clean and has roughness that meets a requirement. Steps including but not limited to chemical mechanical polishing, ion etching, ultrasonic cleaning, and the like may be used to make the bottom structure before growing meet the requirement, and growing of the TM-RE thin film 100 is not affected.

Step 12: Perform annealing processing on the manufactured MTJ.

For example, after a device (or component) including the MTJ is completed, the formed device including the MTJ may be placed in a vacuum environment with a vacuum degree higher than 10⁻⁸ Torr for annealing. For example, annealing time may be 1.5 hours, and annealing temperature may be greater than 400°C. After an annealing process ends, the device is placed in the vacuum environment, naturally cooled to room temperature, and then taken out.

In addition, it may be understood that, when the oxide layer 200 is formed in a sputtering manner, different sputtering rates and thicknesses directly affect roughness and a quantity of defects of the oxide layer 200. Generally, lower roughness of the oxide layer 200 indicates better perpendicular magnetic anisotropy of the TM-RE thin film 100, and higher roughness of the oxide layer 200 indicates poorer perpendicular magnetic anisotropy of the TM-RE thin film 100. Therefore, in practice, the perpendicular magnetic anisotropy and a post-annealing property of the TM-RE thin film 100 may be regulated by regulating parameters such as an oxide type, sputtering power, atmospheric pressure, and a thickness of the oxide layer 200.

In this embodiment, the type and the thickness of the oxide layer 200 are not limited. It is found through experiments that effects of improving (maintaining) perpendicular magnetic anisotropy of the TM-RE thin film 100 after annealing are different when the oxide layer 200 is formed by using different types of oxides at a same thickness. For example, when the thickness of the oxide layer 200 is the same, effect of improving the perpendicular magnetic anisotropy of the TM-RE thin film 100 by using the oxide layer 200 of MgO is better than that of improving the perpendicular magnetic anisotropy of the TM-RE thin film 100 by using the oxide layer 200 of SiO₂. When the type of the oxide is the same, a thicker thickness of the oxide layer 200 indicates a more significant improvement in the perpendicular magnetic anisotropy of the TM-RE thin film 100 after annealing.

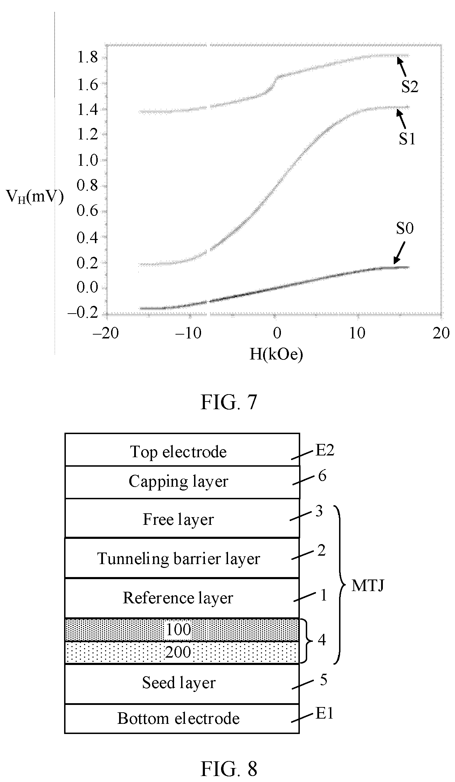

In addition, in practice, improving annealing tolerance of the perpendicular magnetic anisotropy of the TM-RE thin film 100 by using the oxide layer 200 is verified through specific experiments. Refer to FIG. 7. S0 is a hysteresis loop of a multi-film layer structure that has a TM-RE thin film 100 having a surface on which the oxide layer 200 is not disposed and that exists after annealing at 400°C and for 1.5 hours. S1 is a hysteresis loop of a multi-film layer structure that has a TM-RE thin film 100 having a surface on which an MgO layer (200) of a thickness of 0.4 nm is disposed and that exists after annealing at 400°C and for 1.5 hours. S2 is a hysteresis loop of a multi-film layer structure that has a TM-RE thin film 100 having a surface on which an MgO layer (200) of a thickness of 1.0 nm is disposed and that exists after annealing at 400°C and for 1.5 hours.

The hysteresis loop in FIG. 7 is a curve of a relationship between magnetization magnitude (that is, a horizontal coordinate) applied in a direction (that is, a direction z) perpendicular to the TM-RE thin film 100 and a Hall voltage V_{H} (that is, a vertical coordinate). A person skilled in the art may understand that a larger Hall voltage V_{H} indicates greater magnetization in the direction z of the TM-RE thin film 100. Based on this, it can be learned from comparison between S0, S1, and S2 that, compared with a case in which the oxide layer 200 is not disposed (refer to S0), annealing tolerance of the perpendicular magnetic anisotropy of the TM-RE thin film 100 can be significantly improved by providing the oxide layer 200. It can be learned from comparison between S1 and S2 that, when the oxide layer 200 uses a same oxide, a thicker thickness of the oxide layer 200 indicates better annealing tolerance of the perpendicular magnetic anisotropy of the TM-RE thin film 100.

In addition, it should be noted that step 11 is merely an example in which the reference layer 1, the tunneling barrier layer 2, the ferromagnetic layer 30, the interlayer spacer 31, the TM-RE thin film 100, and the oxide layer 200 are sequentially manufactured. In some other possible implementations, the oxide layer 200, the TM-RE thin film 100, the interlayer spacer 31, the ferromagnetic layer 30, the tunneling barrier layer 2, the reference layer 1, the structure conversion layer 41, and the pinned layer 4 may be sequentially manufactured in step 11, to form the MTJ. In this case, the free layer 3 is located on a side of the tunneling barrier layer 2 close to the bottom electrode E1, and the reference layer 1, the structure conversion layer 41, and the pinned layer 4 are sequentially stacked from bottom to top on a side of the tunneling barrier layer 2 close to the top electrode E2.

In conclusion, in Embodiment 1, the TM-RE thin film and the oxide layer are applied to the hybrid free layer of the MTJ. An additional perpendicular magnetic anisotropy source is provided for the TM-RE thin film by using the oxide layer, to improve the annealing tolerance of the perpendicular magnetic anisotropy of the TM-RE thin film. In addition, the hybrid free layer can provide bulk perpendicular magnetic anisotropy (b-PMA) based on the TM-RE thin film.

### Embodiment 2

In an MTJ device provided in this embodiment, a TM-RE thin film and an oxide layer are applied to a pinned layer 4 of the MTJ. In this case, one or more TM-RE thin films are disposed in the pinned layer 4 of the MTJ, and the oxide layer is disposed on at least one surface of some or all of the TM-RE thin films. For example, in the pinned layer 4, the oxide layer may be disposed on an upper surface of the at least one TM-RE thin film, or the oxide layer may be disposed on a lower surface of the at least one TM-RE thin film, or the oxide layer may be disposed on both the upper surface and the lower surface of the at least one TM-RE thin film.

How the TM-RE thin film and the oxide layer in the pinned layer 4 are specifically disposed is described below.

For example, in some possible implementations, as shown in FIG. 8, the pinned layer 4 includes one TM-RE thin film 100 and one oxide layer 200. The oxide layer 200 is located on a side of the TM-RE thin film 100 away from a tunneling barrier layer 2, that is, the oxide layer 200 is located on the lower surface of the TM-RE thin film 100. Certainly, in another possible implementation, outside the present invention, the oxide layer 200 may alternatively be disposed on the upper surface of the TM-RE thin film 100.

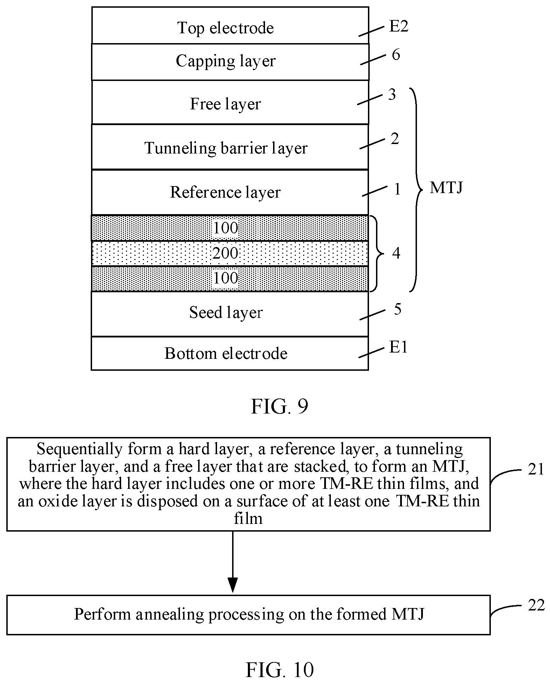

For another example, in some possible implementations, as shown in FIG. 9, the pinned layer 4 includes two TM-RE thin films 100 and one oxide layer 200. The oxide layer 200 is disposed between the two TM-RE thin films 100.

For another example, in some possible implementations, outside the present invention, the pinned layer 4 may include one TM-RE thin film 100 and two oxide layers 200. The TM-RE thin film 100 may be disposed between the two oxide layers 200.

Certainly, how the TM-RE thin film 100 and the oxide layer 200 in the pinned layer 4 are disposed is not limited to the foregoing plurality of manners. For example, in some possible implementations, three TM-RE thin films 100 may be disposed in the pinned layer 4. In this case, one oxide layer 200 may be disposed between two adjacent TM-RE thin films 100 separately, or one oxide layer 200 may be disposed on a lower surface or an upper surface of each TM-RE thin film 100 separately. This is not limited in this application. In practice, the TM-RE thin film 100 and the oxide layer 200 in the pinned layer 4 may be disposed based on a requirement. However, according to the present invention, the pinned layer 4 is in direct contact with the reference layer 1 via a TM-RE thin film 100.

In addition, because the TM-RE thin film formed by using a TM-RE material of an amorphous state can improve flatness of a subsequently grown thin film, there is no need to consider stress generated due to lattice mismatch and roughness accumulation. Therefore, when the TM-RE thin film 100 is applied to the pinned layer 4, as shown in FIG. 8 and FIG. 9, the TM-RE thin film 100 may be used in a top layer of the pinned layer 4, and a reference layer 1 is directly formed on a surface of the TM-RE thin film 100, that is, the reference layer 1 is in direct contact with the TM-RE thin film 100 on the top layer of the pinned layer 4. In this case, a requirement of the reference layer 1 on interface flatness is met without a need of additionally separately manufacturing a structure conversion layer (correspondingly, refer to FIG. 5), and a manufacturing process is simplified.

In addition, Embodiment 2 further provides an MTJ device manufacturing method. As shown in FIG. 10, the manufacturing method includes the following steps.

Step 21: Sequentially manufacture a pinned layer 4, a reference layer 1, a tunneling barrier layer 2, and a free layer 3, to form an MTJ, as shown in FIG. 8 and FIG. 9, where the pinned layer 4 includes one or more TM-RE thin films 100, and an oxide layer 200 is disposed on a surface of at least one TM-RE thin film 100.

For example, refer to FIG. 8. Step 21 may include sequentially manufacturing the oxide layer 200, the TM-RE thin film 100, the reference layer 1, the tunneling barrier layer 2, and the free layer 3, to form the MTJ.

For example, refer to FIG. 9. Step 21 may include sequentially manufacturing the TM-RE thin film 100, the oxide layer 200, the TM-RE thin film 100, the reference layer 1, the tunneling barrier layer 2, and the free layer 3, to form the MTJ.

It should be understood that, as shown in FIG. 8 and FIG. 9, for manufacturing of the entire MTJ device, before step 21 is performed, a bottom electrode E1 and a seed layer 5 that are stacked may be first sequentially formed on a substrate; and then manufacturing of the pinned layer 4, the reference layer 1, the tunneling barrier layer 2, and the free layer 3 in step 21 is performed on a surface of the seed layer 5. After step 11, manufacturing of another film layer, for example, a capping layer 6 and a top electrode E2, may continue to be performed on a surface of the free layer 3.

Step 22: Perform annealing processing on the manufactured MTJ.

For example, after a device (or component) including the MTJ is completed, the formed device including the MTJ may be placed in a vacuum environment with a vacuum degree higher than 10⁻⁸ Torr for annealing. Annealing time may be 1.5 hours, and annealing temperature may be greater than 400°C. After an annealing process ends, the device is placed in the vacuum environment, naturally cooled to room temperature, and then taken out.

In addition, for specific materials of the film layers, manufacturing processes of the TM-RE thin film 100 and the oxide layer 200, and related explanations and descriptions, refer to related content in the foregoing Embodiment 1, and details are not described herein again.

It should be noted that FIG. 8 and FIG. 9 are merely examples in which the pinned layer 4 is located on a side of the tunneling barrier layer 2 close to the bottom electrode E1, and the free layer is located on a side of the tunneling barrier layer 2 close to the top electrode E2. In some other possible implementations, the pinned layer 4 may be located on the side of the tunneling barrier layer 2 close to the top electrode E2, and the free layer is located on the side of the tunneling barrier layer 2 close to the bottom electrode E1. Certainly, in this case, a sequence of the film layers formed in step 2 may be adjusted. For example, in some possible implementations, the free layer 3, the tunneling barrier layer 2, the reference layer 1, the TM-RE thin film 100, and the oxide layer 200 may be sequentially manufactured in step 21, to form the MTJ. For another example, in some possible implementations, the free layer 3, the tunneling barrier layer 2, the reference layer 1, the TM-RE thin film 100, the oxide layer 200, and the TM-RE thin film 100 may be sequentially manufactured in step 21, to form the MTJ.

In conclusion, in Embodiment 2, the TM-RE thin film and the oxide layer are applied to the pinned layer of the MTJ. An additional perpendicular magnetic anisotropy source is provided for the TM-RE thin film by using the oxide layer, to improve the annealing tolerance of the perpendicular magnetic anisotropy of the TM-RE thin film. In addition, the TM-RE material forming the TM-RE thin film 100, as a ferrimagnetic material, has a small magnetic moment. This can reduce a leakage magnetic field of the pinned layer, to reduce an offset to the free layer.

Further, because the TM-RE thin film formed by using the TM-RE material of an amorphous state can improve flatness of a subsequently grown thin film, there is no need to consider stress generated due to lattice mismatch and roughness accumulation. Therefore, the TM-RE thin film may be in direct contact with the reference layer when the TM-RE thin film is used to manufacture the pining layer. This can meet a requirement of the reference layer on interface flatness without a need of additionally separately manufacturing a structure conversion layer and simplify a manufacturing process.

It can be learned from the foregoing content that Embodiment 1 is schematically described by using an example in which the TM-RE thin film 100 and the oxide layer 200 are applied to the free layer 3 of the MTJ, and Embodiment 2 is schematically described by using an example in which the TM-RE thin film 100 and the oxide layer 200 are applied to the pinned layer 4 of the MTJ. However, this application is not limited thereto. In some other embodiments, both the free layer 3 and the pinned layer 4 of the MTJ may use the TM-RE thin film 100 and the oxide layer 200. For how to dispose them, refer to related descriptions in Embodiment 1 and Embodiment 2. Details are not described herein again.

In conclusion, it can be learned that a structure and a process of the MTJ device used in embodiments of this application are simple. The perpendicular magnetic anisotropy and annealing characteristic of the TM-RE thin film 100 can be controlled by disposing the oxide layer 200 on the surface of the TM-RE thin film 100. The oxide layer 200 only needs to be grown at normal temperature, and the thickness of the oxide layer 200 only needs to be one to several nanometers to achieve significant effect. This not only can expand an integration condition of the MTJ device and promote development and application of the MTJ device, but also helps study preparation and properties of the MTJ device.

Application of the MTJ device provided in embodiments of this application in a magnetic memory is used as an example below for description with reference to an electronic device.

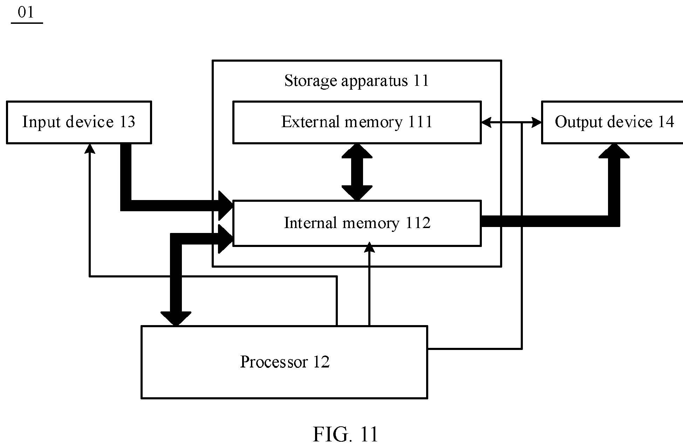

For example, FIG. 11 is a schematic diagram of an architecture of an example of an electronic device according to an embodiment of this application. Refer to FIG. 11. In some possible implementations, the electronic device 01 may include components such as a storage apparatus 11, a processor 12, an input device 13, and an output device 14. The storage apparatus 11 is configured to store a software program and a module. The storage apparatus 11 mainly includes a program storage area and a data storage area. The program storage area may store an operating system, an application required by at least one function (such as a sound play function and an image play function), and the like. The data storage area may store data (such as audio data, image data, and a phone book) created based on use of the electronic device, and the like.

The storage apparatus 11 may include an external memory 111 and an internal memory 112. The external memory 111 and the internal memory 112 may transmit stored data to each other. The external memory 111 includes, for example, a hard disk, a USB flash drive, and a floppy disk. The internal memory 112 includes, for example, a random access memory and a read-only memory. According to the invention, the random access memory is a magnetic random access memory (MRAM) provided in any one of the possible implementations of the foregoing invention Embodiments 1 or 2.

The processor 12 is a control center of the electronic device 01, is connected to all parts of the entire electronic device 01 through various interfaces and lines, and by running or executing the software program and/or the module stored in the storage apparatus 11, and invoking the data stored in the storage apparatus 11, executes various functions of the electronic device 01 and processes data, to perform overall monitoring on the electronic device 01.

The input device 13 is configured to: receive input digital or character information, and generate a key signal input related to a user setting and function control of the electronic device 01. The output device 14 is configured to output a signal corresponding to data that is input by the input device 13 and that is stored in the internal memory 112. For example, the output device 14 outputs a sound signal or a video signal. A controller in the processor 12 may further control the output device 14 to output a signal or not to output a signal.

It should be understood that the MRAM is a new type of a non-volatile memory. A spin transfer torque magnetic random access memory (STT MRAM) in the MRAM has advantages such as a high speed, low power consumption, and good compatibility with complementary metal oxide semiconductor (CMOS) technology.

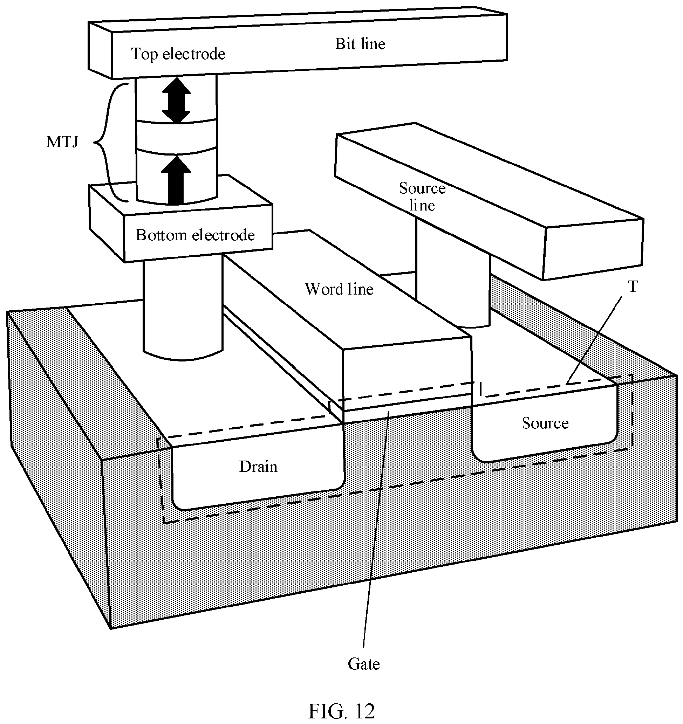

Read and write functions of the STT MRAM are implemented by an internally disposed storage unit. For example, refer to FIG. 12. In some possible implementations, the storage unit of the STT MRAM may include a transistor T and the MTJ device provided in any one of the possible implementations provided in embodiments of this application. A top electrode of the MTJ device is electrically connected to a bit line, a bottom electrode of the MTJ device is electrically connected to a drain of the transistor T, a gate of the transistor T is electrically connected to a word line, and a source is electrically connected to a source line.

The foregoing descriptions are merely specific implementations of this application, but are not intended to limit the protection scope of this application. Any variation or replacement readily figured out by a person skilled in the art within the technical scope disclosed in this application and falling within the scope of the present invention could be made. Anyway, the protection scope of the present invention is the protection scope of the claims.

## Claims

1. A magnetic device, comprising a magnetic tunnel junction (MTJ), wherein
the magnetic tunnel junction comprises a pinned layer (4), a reference layer (1), a tunneling barrier layer (2), and a free layer (3) that are sequentially stacked; and
at least one of the pinned layer (4) or the free layer (3) comprises a transition metal rare earth ferrimagnetic alloy thin film (100) and an oxide layer (200) located on a surface of the transition metal rare earth ferrimagnetic alloy thin film (100);
wherein the free layer (3) comprises a ferromagnetic layer (30), an interlayer spacer (31), the transition metal rare earth ferrimagnetic alloy thin film (100), and the oxide layer (200) that are sequentially stacked, and the ferromagnetic layer (30) is in contact with the tunneling barrier layer (2); or
wherein the pinned layer (4) comprises one or more transition metal rare earth ferrimagnetic alloy thin films (100), wherein the oxide layer (200) is disposed on a surface of at least one transition metal rare earth ferrimagnetic alloy thin film (100) close to and/or away from the tunneling barrier layer (2), and the pinned layer (4) is in direct contact with the reference layer (1) by using the transition metal rare earth ferrimagnetic alloy thin film (100).

2. The magnetic device according to claim 1, wherein the transition metal rare earth ferrimagnetic alloy thin film (100) comprises a transition metal rare earth ferrimagnetic alloy material;
a transition metal element in the transition metal rare earth ferrimagnetic alloy material comprises at least one of Co, Fe, or Ni; and
a rare earth element in the transition metal rare earth ferrimagnetic alloy material comprises at least one of Tb, Gd, Dy, or Eu.

3. The magnetic device according to claim 2, wherein
the transition metal rare earth ferrimagnetic alloy material further comprises at least one doping element of Ta, W, Si, B, or C.

4. The magnetic device according to any one of claims 1 to 3, wherein
the transition metal rare earth ferrimagnetic alloy thin film (100) comprises at least one of CoTb, FeTb, CoGd, CoTbB, FeTbB, of CoGdB.

5. The magnetic device according to any one of claims 1 to 4, wherein
an oxide in the oxide layer (200) comprises at least one of a magnesium-containing oxide, a copper-containing oxide, an aluminum-containing oxide, a zinc-containing oxide, a nickel-containing oxide, a chromium-containing oxide, a titanium-containing oxide, a silicon-containing oxide, or a selenium-containing oxide.

6. The magnetic device according to any one of claims 1 to 5, wherein
the oxide layer (200) comprises at least one of MgO, SiO₂, or MgAlO₃.

7. The magnetic device according to any of claims 1 to 6, wherein
the pinned layer (4) comprises one transition metal rare earth ferrimagnetic alloy thin film (100) and one oxide layer (200); and
the oxide layer (200) is disposed on a surface of the transition metal rare earth ferrimagnetic alloy thin film (100) away from the tunneling barrier layer (2).

8. The magnetic device according to any of claims 1 to 6, wherein
the pinned layer (4) comprises two transition metal rare earth ferrimagnetic alloy thin films (100) and one oxide layer (200); and
the oxide layer (200) is located between the two transition metal rare earth ferrimagnetic alloy thin films (100).

9. A magnetic device manufacturing method, comprising:
manufacturing (step 11, 21) a magnetic tunnel junction (MTJ), wherein the magnetic tunnel junction comprises a pinned layer (4), a reference layer (1), a tunneling barrier layer (2), and a free layer (3) that are sequentially stacked, and at least one of the pinned layer (4) or the free layer (3) comprises a transition metal rare earth ferrimagnetic alloy thin film (100) and an oxide layer (200) located on a surface of the transition metal rare earth ferrimagnetic alloy thin film (100);
wherein the free layer (3) comprises a ferromagnetic layer (30), an interlayer spacer (31), the transition metal rare earth ferrimagnetic alloy thin film (100), and the oxide layer (200) that are sequentially stacked, and the ferromagnetic layer (30) is in contact with the tunneling barrier layer (2); or
wherein the pinned layer (4) comprises one or more transition metal rare earth ferrimagnetic alloy thin films (100), wherein the oxide layer (200) is disposed on a surface of at least one transition metal rare earth ferrimagnetic alloy thin film (100) close to and/or away from the tunneling barrier layer (2), and the pinned layer (4) is in direct contact with the reference layer (1) by using the transition metal rare earth ferrimagnetic alloy thin film (100);
and
performing annealing processing (step 12, 22) on the manufactured magnetic tunnel junction (MTJ).

10. The magnetic device manufacturing method according to claim 9, wherein
the manufacturing a magnetic tunnel junction (step 11) comprises:
sequentially manufacturing the reference layer (1), the tunneling barrier layer (2), the ferromagnetic layer (30), the interlayer spacer (31), the transition metal rare earth ferrimagnetic alloy thin film (100), and the oxide layer (200), to form the magnetic tunnel junction (MTJ), wherein the ferromagnetic layer (30), the interlayer spacer (31), the transition metal rare earth ferrimagnetic alloy thin film (100), and the oxide layer (200) that are sequentially manufactured form the free layer (3); or
sequentially manufacturing the oxide layer, the transition metal rare earth ferrimagnetic alloy thin film (100), the interlayer spacer (31), the ferromagnetic layer (30), the tunneling barrier layer (2), and the reference layer (1), to form the magnetic tunnel junction (MTJ), wherein the oxide layer (200), the transition metal rare earth ferrimagnetic alloy thin film (100), the interlayer spacer (31), and the ferromagnetic layer (30) that are sequentially manufactured form the free layer (3).

11. The magnetic device manufacturing method according to claim 9, wherein
the manufacturing a magnetic tunnel junction (step 21) comprises:
sequentially manufacturing the oxide layer (200), the transition metal rare earth ferrimagnetic alloy thin film (100), the reference layer (1), the tunneling barrier layer (2), and the free layer (3), to form the magnetic tunnel junction (MTJ), wherein the oxide layer (200) and the transition metal rare earth ferrimagnetic alloy thin film (100) that are sequentially manufactured form the pinned layer (4); or
sequentially manufacturing the free layer (3), the tunneling barrier layer (2), the reference layer (1), the transition metal rare earth ferrimagnetic alloy thin film (100), and the oxide layer (200), to form the magnetic tunnel junction (MTJ), wherein the transition metal rare earth ferrimagnetic alloy thin film (100) and the oxide layer (200) that are sequentially manufactured form the pinned layer (4).

12. An electronic device (01), comprising a printed circuit board and a magnetic memory (112), wherein the magnetic memory is connected to the printed circuit board, and the magnetic memory comprises a controller and the magnetic device according to any one of claims 1 to 8, wherein the magnetic device is connected to the controller.

## Patentansprüche

1. Magnetische Vorrichtung, umfassend einen magnetischen Tunnelkontakt (MTJ), wobei
der magnetische Tunnelkontakt eine fixierte Schicht (4), eine Referenzschicht (1), eine Tunnelbarriereschicht (2) und eine freie Schicht (3) umfasst, die aufeinanderfolgend gestapelt sind; und
mindestens eine der fixierten Schicht (4) oder der freien Schicht (3) einen Dünnfilm (100) aus einer ferrimagnetischen Übergangsmetall-Seltenerd-Legierung und eine Oxidschicht (200), die sich auf einer Oberfläche des Dünnfilms (100) aus der ferrimagnetischen Übergangsmetall-Seltenerd-Legierung befindet, umfasst;
wobei die freie Schicht (3) eine ferromagnetische Schicht (30), einen Zwischenschichtabstandshalter (31), den Dünnfilm (100) aus der ferrimagnetischen Übergangsmetall-Seltenerd-Legierung und die Oxidschicht (200), die aufeinanderfolgend gestapelt sind, umfasst und die ferromagnetische Schicht (30) mit der Tunnelbarriereschicht (2) in Kontakt steht; oder
wobei die fixierte Schicht (4) einen oder mehrere Dünnfilme (100) aus der ferrimagnetischen Übergangsmetall-Seltenerd-Legierung umfasst, wobei die Oxidschicht (200) auf einer Oberfläche von mindestens einem Dünnfilm (100) aus der ferrimagnetischen Übergangsmetall-Seltenerd-Legierung nahe und/oder entfernt von der Tunnelbarriereschicht (2) angeordnet ist und die fixierte Schicht (4) unter Verwendung des Dünnfilms (100) aus der ferrimagnetischen Übergangsmetall-Seltenerd-Legierung in direktem Kontakt mit der Referenzschicht (1) steht.

2. Magnetische Vorrichtung nach Anspruch 1, wobei der Dünnfilm (100) aus der ferrimagnetischen Übergangsmetall-Seltenerd-Legierung ein ferrimagnetisches Übergangsmetall-Seltenerd-Legierungsmaterial umfasst;
ein Übergangsmetall-Element in dem ferrimagnetischen Übergangsmetall-Seltenerd-Legierungsmaterial mindestens eines der Elemente Co, Fe oder Ni umfasst; und
ein Seltenerd-Element in dem ferrimagnetischen Übergangsmetall-Seltenerd-Legierungsmaterial mindestens eines von Tb, Gd, Dy oder Eu umfasst.

3. Magnetische Vorrichtung nach Anspruch 2, wobei
das ferrimagnetische Übergangsmetall-Seltenerd-Legierungsmaterial ferner mindestens ein Dotierungselement von Ta, W, Si, B oder C umfasst.

4. Magnetische Vorrichtung nach einem der Ansprüche 1 bis 3, wobei
der Dünnfilm (100) aus der ferrimagnetischen Übergangsmetall-Seltenerd-Legierung mindestens eines von CoTb, FeTb, CoGd, CoTbB, FeTbB oder CoGdB umfasst.

5. Magnetische Vorrichtung nach einem der Ansprüche 1 bis 4, wobei
ein Oxid in der Oxidschicht (200) mindestens eines von einem magnesiumhaltigen Oxid, einem kupferhaltigen Oxid, einem aluminiumhaltigen Oxid, einem zinkhaltigen Oxid, einem nickelhaltigen Oxid, einem chromhaltigen Oxid, einem titanhaltigen Oxid, einem siliciumhaltigen Oxid oder einem selenhaltigen Oxid umfasst.

6. Magnetische Vorrichtung nach einem der Ansprüche 1 bis 5, wobei
die Oxidschicht (200) mindestens eines von MgO, SiO₂ oder MgAlO₃ umfasst.

7. Magnetische Vorrichtung nach einem der Ansprüche 1 bis 6, wobei
die fixierte Schicht (4) einen Dünnfilm (100) aus der ferrimagnetischen Übergangsmetall-Seltenerd-Legierung und eine Oxidschicht (200) umfasst; und
die Oxidschicht (200) auf einer Oberfläche des Dünnfilms (100) aus der ferrimagnetischen Übergangsmetall-Seltenerd-Legierung entfernt von der Tunnelbarriereschicht (2) angeordnet ist.

8. Magnetische Vorrichtung nach einem der Ansprüche 1 bis 6, wobei
die fixierte Schicht (4) zwei Dünnfilme (100) aus der ferrimagnetischen Übergangsmetall-Seltenerd-Legierung und eine Oxidschicht (200) umfasst; und
sich die Oxidschicht (200) zwischen den beiden Dünnfilmen (100) aus der ferrimagnetischen Übergangsmetall-Seltenerd-Legierung befindet.

9. Herstellungsverfahren für magnetische Vorrichtungen, umfassend:
Herstellen (Schritt 11, 21) eines magnetischen Tunnelkontakts (MTJ), wobei der magnetische Tunnelkontakt eine fixierte Schicht (4), eine Referenzschicht (1), eine Tunnelbarriereschicht (2) und eine freie Schicht (3), die aufeinanderfolgend gestapelt sind, umfasst und mindestens eine der fixierten Schicht (4) oder der freien Schicht (3) einen Dünnfilm (100) aus der ferrimagnetischen Übergangsmetall-Seltenerd-Legierung und eine Oxidschicht (200), die sich auf einer Oberfläche des Dünnfilms (100) aus der ferrimagnetischen Übergangsmetall-Seltenerd-Legierung befindet, umfasst;
wobei die freie Schicht (3) eine ferromagnetische Schicht (30), einen Zwischenschichtabstandshalter (31), den Dünnfilm (100) aus der ferrimagnetischen Übergangsmetall-Seltenerd-Legierung und die Oxidschicht (200), die aufeinanderfolgend gestapelt sind, umfasst und die ferromagnetische Schicht (30) mit der Tunnelbarriereschicht (2) in Kontakt steht; oder
wobei die fixierte Schicht (4) einen oder mehrere Dünnfilme (100) aus der ferrimagnetischen Übergangsmetall-Seltenerd-Legierung umfasst, wobei die Oxidschicht (200) auf einer Oberfläche von mindestens einem Dünnfilm (100) aus der ferrimagnetischen Übergangsmetall-Seltenerd-Legierung nahe und/oder entfernt von der Tunnelbarriereschicht (2) angeordnet ist und die fixierte Schicht (4) unter Verwendung des Dünnfilms (100) aus der ferrimagnetischen Übergangsmetall-Seltenerd-Legierung in direktem Kontakt mit der Referenzschicht (1) steht; und
Durchführen einer Glühbearbeitung (Schritt 12, 22) an dem hergestellten magnetischen Tunnelkontakt (MTJ).

10. Herstellungsverfahren für magnetische Vorrichtungen nach Anspruch 9, wobei das Herstellen eines magnetischen Tunnelkontakts (Schritt 11) Folgendes umfasst:
aufeinanderfolgendes Herstellen der Referenzschicht (1), der Tunnelbarriereschicht (2), der ferromagnetischen Schicht (30), des Zwischenschichtabstandhalters (31), des Dünnfilms (100) aus einer ferrimagnetischen Übergangsmetall-Seltenerd-Legierung und der Oxidschicht (200), um den magnetischen Tunnelkontakt (MTJ) zu bilden,
wobei die ferromagnetische Schicht (30), der Zwischenschichtabstandshalter (31), der Dünnfilm (100) aus der ferrimagnetischen Übergangsmetall-Seltenerd-Legierung und die Oxidschicht (200), die aufeinanderfolgend hergestellt werden, die freie Schicht (3) bilden; oder
aufeinanderfolgendes Herstellen der Oxidschicht, des Dünnfilms (100) aus der ferrimagnetischen Übergangsmetall-Seltenerd-Legierung, des Zwischenschichtabstandhalters (31), der ferromagnetischen Schicht (30), der Tunnelbarriereschicht (2) und der Referenzschicht (1), um den magnetischen Tunnelkontakt (MTJ) zu bilden,
wobei die Oxidschicht (200), der Dünnfilm (100) aus der ferrimagnetischen Übergangsmetall-Seltenerd-Legierung, der Zwischenschichtabstandhalter (31) und die ferromagnetische Schicht (30), die aufeinanderfolgend hergestellt werden, die freie Schicht (3) bilden.

11. Herstellungsverfahren für magnetische Vorrichtungen nach Anspruch 9, wobei das Herstellen eines magnetischen Tunnelkontakts (Schritt 21) Folgendes umfasst:
aufeinanderfolgendes Herstellen der Oxidschicht (200), des Dünnfilms (100) aus der ferrimagnetischen Übergangsmetall-Seltenerd-Legierung, der Referenzschicht (1), der Tunnelbarriereschicht (2) und der freien Schicht (3), um den magnetischen Tunnelkontakt (MTJ) zu bilden,
wobei die Oxidschicht (200) und der Dünnfilm (100) aus der ferrimagnetischen Übergangsmetall-Seltenerd-Legierung, die aufeinanderfolgend hergestellt werden, die fixierte Schicht (4) bilden; oder
aufeinanderfolgendes Herstellen der freien Schicht (3), der Tunnelbarriereschicht (2), der Referenzschicht (1), des Dünnfilms (100) aus der ferrimagnetischen Übergangsmetall-Seltenerd-Legierung und der Oxidschicht (200), um den magnetischen Tunnelkontakt (MTJ) zu bilden,
wobei der Dünnfilm (100) aus der ferrimagnetischen Übergangsmetall-Seltenerd-Legierung und die Oxidschicht (200), die aufeinanderfolgend hergestellt werden, die fixierte Schicht (4) bilden.

12. Elektronische Vorrichtung (01), umfassend eine Leiterplatte und einen magnetischen Speicher (112), wobei der magnetische Speicher mit der Leiterplatte verbunden ist und der magnetische Speicher eine Steuerung und die magnetische Vorrichtung nach einem der Ansprüche 1 bis 8 umfasst, wobei die magnetische Vorrichtung mit der Steuerung verbunden ist.

## Revendications

1. Dispositif magnétique, comprenant une jonction à effet tunnel magnétique (MTJ), dans lequel la jonction à effet tunnel magnétique comprend une couche fixée (4), une couche de référence (1), une couche barrière tunnel (2), et une couche libre (3) qui sont empilées séquentiellement ; et
au moins l'une des couches fixées (4) ou de la couche libre (3) comprend un film mince d'alliage ferrimagnétique de terres rares de métal de transition (100) et une couche d'oxyde (200) située sur une surface du film mince d'alliage ferrimagnétique de terres rares de métal de transition (100) ;
dans lequel la couche libre (3) comprend une couche ferromagnétique (30), un espaceur intercouche (31), le film mince d'alliage ferrimagnétique de terres rares de métal de transition (100), et la couche d'oxyde (200) qui sont empilés séquentiellement, et la couche ferromagnétique (30) est en contact avec la couche barrière tunnel (2) ; ou
dans lequel la couche fixée (4) comprend un ou plusieurs films minces d'alliage ferrimagnétique de terres rares de métal de transition (100), dans lequel la couche d'oxyde (200) est disposée sur une surface d'au moins un film mince d'alliage ferrimagnétique de terres rares de métal de transition (100) près et/ou loin de la couche barrière tunnel (2), et la couche fixée (4) est en contact direct avec la couche de référence (1) en utilisant le film mince d'alliage ferrimagnétique de terres rares de métal de transition (100).

2. Dispositif magnétique selon la revendication 1, dans lequel le film mince d'alliage ferrimagnétique de terres rares de métal de transition (100) comprend un matériau d'alliage ferrimagnétique de terres rares de métal de transition ;
un élément de métal de transition dans le matériau d'alliage ferrimagnétique de terres rares de métal de transition comprend au moins l'un du Co, du Fe ou du Ni ; et
un élément de terre rare dans le matériau d'alliage ferrimagnétique de terres rares de métal de transition comprend au moins l'un du Tb, du Gd, du Dy, ou de l'Eu.

3. Dispositif magnétique selon la revendication 2, dans lequel le matériau d'alliage ferrimagnétique de terres rares de métal de transition comprend également au moins un élément dopant de Ta, W, Si, B, ou C.

4. Dispositif magnétique selon l'une quelconque des revendications 1 à 3, dans lequel
le film mince d'alliage ferrimagnétique de terres rares de métal de transition (100) comprend au moins l'un des composés suivants : CoTb, FeTb, CoGd, CoTbB, FeTbB, ou CoGdB.

5. Dispositif magnétique selon l'une quelconque des revendications 1 à 4, dans lequel
un oxyde dans la couche d'oxyde (200) comprend au moins l'un d'un oxyde contenant du magnésium, d'un oxyde contenant du cuivre, d'un oxyde contenant de l'aluminium, d'un oxyde contenant du zinc, d'un oxyde contenant du nickel, d'un oxyde contenant du chrome, d'un oxyde contenant du titane, d'un oxyde contenant du silicium, ou d'un oxyde contenant du sélénium.

6. Dispositif magnétique selon l'une quelconque des revendications 1 à 5, dans lequel
la couche d'oxyde (200) comprend au moins l'un des composés suivants : MgO, SiO₂, ou MgAlO₃.

7. Dispositif magnétique selon l'une quelconque des revendications 1 à 6, dans lequel
la couche fixée (4) comprend un film mince d'alliage ferrimagnétique de terres rares de métal de transition (100) et une couche d'oxyde (200) ; et
la couche d'oxyde (200) est disposée sur une surface du film mince d'alliage ferrimagnétique de terres rares de métal de transition (100) loin de la couche barrière tunnel (2).

8. Dispositif magnétique selon l'une quelconque des revendications 1 à 6, dans lequel
la couche fixée (4) comprend deux films minces d'alliage ferrimagnétique de terres rares de métal de transition (100) et une couche d'oxyde (200) ; et
la couche d'oxyde (200) est située entre les deux films minces d'alliage ferrimagnétique de terres rares de métal de transition (100).

9. Procédé de fabrication de dispositif magnétique, comprenant :
la fabrication (étape 11, 21) d'une jonction à effet tunnel magnétique (MTJ), dans lequel la jonction à effet tunnel magnétique comprend une couche fixée (4), une couche de référence (1), une couche barrière tunnel (2), et une couche libre (3) qui sont empilées séquentiellement, et au moins l'une de la couche fixée (4) ou de la couche libre (3) comprend un film mince d'alliage ferrimagnétique de terres rares de métal de transition (100) et une couche d'oxyde (200) située sur une surface du film mince d'alliage ferrimagnétique de terres rares de métal de transition (100) ;
dans lequel la couche libre (3) comprend une couche ferromagnétique (30), un espaceur intercouche (31), le film mince d'alliage ferrimagnétique de terres rares de métal de transition (100), et la couche d'oxyde (200) qui sont empilés séquentiellement, et la couche ferromagnétique (30) est en contact avec la couche barrière tunnel (2) ; ou
dans lequel la couche fixée (4) comprend un ou plusieurs films minces d'alliage ferrimagnétique de terres rares de métal de transition (100), dans lequel la couche d'oxyde (200) est disposée sur une surface d'au moins un film mince d'alliage ferrimagnétique de terres rares de métal de transition (100) près et/ou loin de la couche barrière tunnel (2), et la couche fixée (4) est en contact direct avec la couche de référence (1) en utilisant le film mince d'alliage ferrimagnétique de terres rares de métal de transition (100) ; et
la réalisation d'un traitement de recuit (étape 12, 22) sur la jonction à effet tunnel magnétique (MTJ) fabriquée.

10. Procédé de fabrication de dispositif magnétique selon la revendication 9, dans lequel
la fabrication d'une jonction à effet tunnel magnétique (étape 11) comprend :
la fabrication séquentielle de la couche de référence (1), de la couche barrière tunnel (2), de la couche ferromagnétique (30), de l'espaceur intercouche (31), du film mince d'alliage ferrimagnétique de terres rares de métal de transition (100), et de la couche d'oxyde (200), pour former la jonction à effet tunnel magnétique (MTJ),
dans lequel la couche ferromagnétique (30), l'espaceur intercouche (31), le film mince d'alliage ferrimagnétique de terres rares de métal de transition (100), et la couche d'oxyde (200) qui sont fabriqués séquentiellement forment la couche libre (3) ; ou
la fabrication séquentielle de la couche d'oxyde, du film mince d'alliage ferrimagnétique de terres rares de métal de transition (100), de l'espaceur intercouche (31), de la couche ferromagnétique (30), de la couche barrière tunnel (2), et de la couche de référence (1), pour former la jonction à effet tunnel magnétique (MTJ),
dans lequel la couche d'oxyde (200), le film mince d'alliage ferrimagnétique de terres rares de métal de transition (100), l'espaceur intercouche (31), et la couche ferromagnétique (30) qui sont fabriqués séquentiellement forment la couche libre (3).

11. Procédé de fabrication de dispositif magnétique selon la revendication 9, dans lequel
la fabrication d'une jonction à effet tunnel magnétique (étape 21) comprend :
la fabrication séquentielle de la couche d'oxyde (200), du film mince d'alliage ferrimagnétique de terres rares de métal de transition (100), de la couche de référence (1), de la couche barrière tunnel (2), et de la couche libre (3), pour former la jonction à effet tunnel magnétique (MTJ),
dans lequel la couche d'oxyde (200) et le film mince d'alliage ferrimagnétique de terres rares de métal de transition (100) qui sont fabriqués séquentiellement forment la couche fixée (4) ; ou
la fabrication séquentielle de la couche libre (3), de la couche barrière tunnel (2), de la couche de référence (1), du film mince d'alliage ferrimagnétique de terres rares de métal de transition (100), et de la couche d'oxyde (200), pour former la jonction à effet tunnel magnétique (MTJ),
dans lequel le film mince d'alliage ferrimagnétique de terres rares de métal de transition (100) et la couche d'oxyde (200) qui sont fabriqués séquentiellement forment la couche fixée (4).

12. Dispositif électronique (01), comprenant une carte de circuit imprimé et une mémoire magnétique (112), dans lequel la mémoire magnétique est connectée à la carte de circuit imprimé, et la mémoire magnétique comprend un dispositif de commande et le dispositif magnétique selon l'une quelconque des revendications 1 à 8, dans lequel le dispositif magnétique est connecté au dispositif de commande.
